# EUROPEAN PATENT SPECIFICATION

(11) **EP 0 698 270 B1**
(45) Date of publication and mention of the grant of the patent: **26.07.2000**
(21) Application number: 95907127.5
(22) Date of filing: 14.02.1995
(51) Int. Cl.: G11B 20/12, G11B 20/18, H03M 13/00

(54) **RECORD CARRIER AND DEVICE FOR READING SUCH A RECORD CARRIER**
AUFZEICHNUNGSTRÄGER UND VORRICHTUNG ZUM LESEN EINES DERARTIGEN TRÄGERS
SUPPORT D'ENREGISTREMENT ET DISPOSITIF DE LECTURE D'UN TEL SUPPORT

(30) Priority: 16.02.1994 EP 94200339
(43) Date of publication of application: 28.02.1996
(73) Proprietor: Koninklijke Philips Electronics N.V., 5621 BA Eindhoven (NL); PHILIPS NORDEN AB, 164 85 Stockholm (SE)
(72) Inventor: MONS, Johannes, Jan, NL-5621 BA Eindhoven (NL)
(74) Representative: Groenendaal, Antonius Wilhelmus Maria
(86) International application number: IB9500101
(87) International publication number: WO9522824

(56) References cited:
- WO-A-92/11635
- GB-A- 2 265 047
- US-A- 4 955 022

## Description

The invention relates to a record carrier on which is recorded a data signal representing data words, added first-type code words and added second-type code words, the first-type code words having a predefined first relation to the data words, and the second-type code words having a predefined second relation to the data words and first-type code words, the predefined first and second relations enabling error correction in accordance with a predetermined algorithm, and the data signal being subdivided into addressable blocks which comprise each a control portion containing control data words and a data portion containing user-supplied data words.

The invention further relates to a device for writing and a device for reading a record carrier.

Such a record carrier and device are known, for example, by the name of CD-ROM and CD-ROM player.

The user-supplied data on a CD-ROM is recorded in a so-termed main channel. Furthermore, the so-termed subcode channel contains addresses in the form of so-termed absolute time codes. The data in the main channel are subdivided into blocks customarily referred to as sectors. Each sector comprises a so-termed sector header which contains, amongst other things, a sector address which corresponds to the absolute time code in the subcode channel, and a data portion which contains the actual user-supplied data. Prior to the data being recorded on the CD-ROM, these data are subjected to a so-termed CIRC process which makes error correction possible. In this process so-termed P-redundancy code words and so-termed Q-redundancy code words are added. Besides, the data from the same sector are distributed over a large portion of the recorded signal. The result of this distribution (also denoted interleaving) is that, when the signal is read out, the data of a sector will not be available until the time has elapsed that is necessary for reading the data signal portion over which the data words (and associated P and Q-redundancy code words) for the appropriate sector have been distributed. Contrary to the data in the main channel the data in the subcode channel are available nearly immediately. For a rapid search on a record carrier for a sector having a specific address, the address data in the subcode channel are used. A drawback of the recording of a subcode channel is that, as a result, the space available for recording the main channel is reduced.

It is an object of the invention to provide a record carrier on which the blocks recorded on the record carrier can be searched rapidly without using a subcode channel.

This object is achieved by a record carrier as defined in claim 1. As the length of the data signal portion over which the data words of a block are distributed is relatively small, the time necessary for getting data words of the control portions of a block available is relatively short. Although all the available redundant data about data words of the control portion, which words might be received erroneously, has not yet arrived then, these still (partly) uncorrected data words are generally sufficiently reliable to be used to search blocks on the record carrier. The control portion preferably contains data words representing an address. The invention is not restricted thereto. It is alternatively possible that the control portion either or not combined with the address data contain other control data for which it is desirable that the latter be rapidly available during the reading operation.

A further embodiment for the record carrier is characterized in that the control portion contains added data words which have a predefined relation to data words in the control portion, whilst types of errors in the data words in the control portion can be detected in response to the data words and the added data words.

Detection of erroneously received data words in the control portion is possible because of the added data words, so that search procedures based upon erroneous control data can be avoided.

A record carrier according to the invention may be read out by a device according to claim 4. Further a record carrier according to the invention may be recorded by a device according to claim 8.

The invention will be further explained in the following with reference to the drawing Figures 1 to 4, in which:
Fig. 1 shows a data signal;
Fig. 2 shows a format of the data signal;
Fig. 3 shows a device for converting data to a modulated signal suitable for recording, and
Fig. 4 shows a device for recovering data from a signal detected from a record carrier.

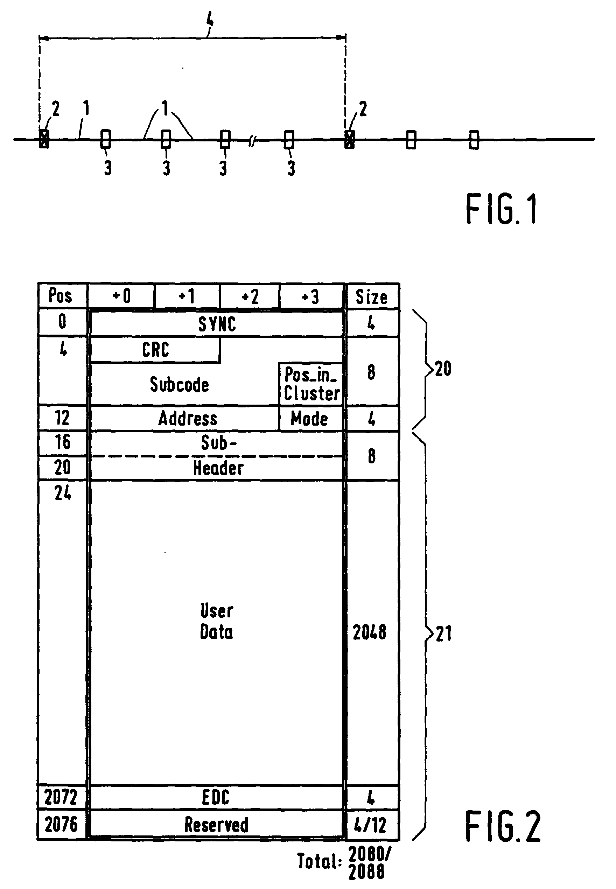

Fig. 1 shows a data signal which is subdivided into blocks 1. Each of the blocks comprises a synchronization (sync) portion 2 or 3 and a data portion. The data portion comprises a number of n-bit data words. In the embodiment described here n is equal to 8. These n-bit data words will also be referenced (data) bytes. The blocks 1 are grouped in clusters 4 of q blocks. Possible values for q are, for example, 4 or 16. The data signal is intended to be recorded on a record carrier, for example, a record carrier of an optically detectable type. However, other types of record carriers, for example, a magnetic type, are likewise possible. Prior to being recorded, the data words are extended by redundancy codewords which make error correction possible. Subsequently, the data words and added redundancy codewords are converted to a modulated signal which has signal properties tuned to the type of record carrier on which the modulated signal is recorded. In the modulated signal the data words and added redundancy codewords are represented by a series of codes which uniquely determine the data words and code words. The conversion of data words and code words to the modulated signal may be of a type as described in European Patent application No. 94200387.2 (PHN 14.746). Alternatively, however, other modulations such as, for example, a so-termed EFM modulation are likewise possible. The sync portions 2 and 3 in the modulated signal are preferably represented by codes not used for the data words and added codewords. Furthermore, there should be a preference for using for sync portions 2, accommodated in the first block 1 of each cluster, different codes from those for the sync portions 3 in the other blocks 1 of the cluster 4.

Fig. 2 shows in greater detail a preferred embodiment for a format of the blocks 1. In the format shown the bytes (data words) are grouped in rows of four bytes each. To the left of these rows is shown the serial number of the first byte of the row concerned. At the top the position of the bytes in the column is shown by the numbers "+0", "+1", "+2" and "+3". The first four byte positions, denoted "SYNC" in the format are intended for the sync portion 2 or sync portion 3. In addition to the SYNC portion the block comprises a control portion 20 (bytes "4" to "11" inc) and a data portion (byte "12" up to and including the last byte of block 1). The control portion comprises three bytes which contain a sector address. The control portion may further comprise other control data, for example, as they are customarily included in the subcode channel on a Compact Disc. The bytes containing these data are referenced "Subcode". These bytes preferably comprise a byte denoting a so-termed Copy Right Class. The control portion further comprises a so-termed MODE byte which denotes the type of format. This MODE byte has a different value from the value used with CD-ROM.

The Pos_in_Cluster byte indicates the position of the relevant sector in a cluster.

Furthermore, there should be a preference for the control portion 20 to comprise 20 CRC bytes. These bytes have a predefined relation to the other bytes in the control portion, so that detection of an erroneous transfer of the control portion bytes is possible. This relation may be one as described in detail in the title "THE ART OF DIGITAL AUDIO" by J. Watkinson (ISBN 0-240-51270-7).

The data portion 21 comprises a Sub-Header, for example, one used in the data blocks a CD-ROM or CD-I signal is divided into. Furthermore the greater part of the data portion is formed by bytes containing the actual user-supplied data (User Data). The data portion 21 may further contain a number of bytes EDC which have a predefined relation to the other bytes in the data portion and which make a detection of erroneous data transfer possible.

In the format described hereinbefore, the boundary between the control portion 20 and the data portion 21 is selected such that the Sub-Header belongs to the data portion 21. The boundary may, however, as well be selected such that the Sub-Header belongs to the control portion 20.

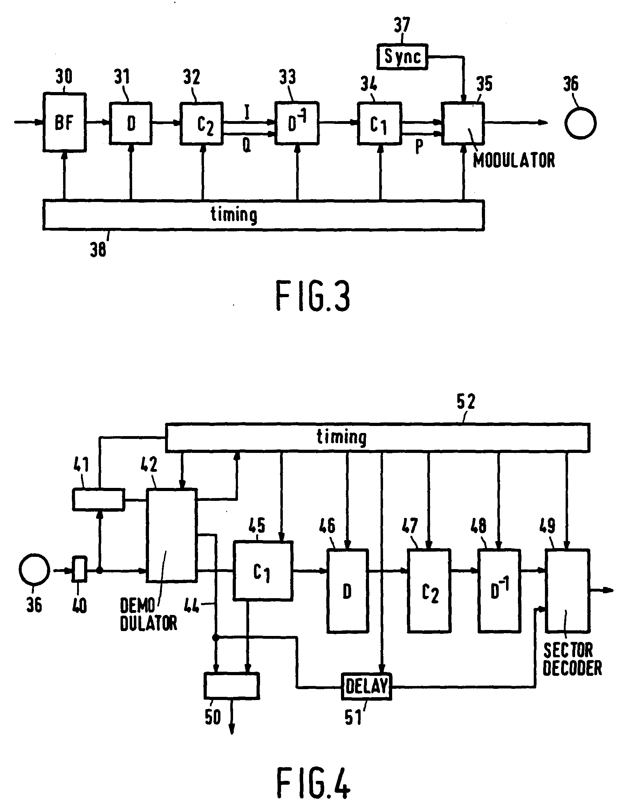

Fig. 3 shows an embodiment for a device by which a signal having the block format shown in Fig. 2 can be recorded on a record carrier. This device comprises a block formatter 30 formatting, in the format shown in Fig. 2 and in a customary fashion, the user-supplied data to be recorded. The whole block 1 is then formed except for the sync portion 2 or 3.

The blocks formed by the block formatter are applied to a so-termed interleaver of a customary type, which reorders the bytes of the blocks in that the bytes of the various blocks are interleaved. For a detailed description of such interleaving, reference be made to said tide "THE ART OF DIGITAL AUDIO", more specifically, page 466. The interleaver 31 is followed by a C₂ decoder 32 which adds Q-redundancy bytes to the interleaved sequence of data bytes in a manner as described in chapter 7 of said title. The interleaved data bytes and Q-redundancy bytes are applied to a deinterleaver 33 which reorders the interleaved data bytes and added Q-redundancy bytes in a manner in which the data bytes are put back in an order that corresponds to the order as it was on the output of the formatter 30. The Q-redundancy bytes which belong to data bytes of a sector are then distributed over a large area. The data bytes produced by the deinterleaver and Q-redundancy bytes are applied to a C1 encoder which adds to the received bytes so-termed P-redundancy bytes in a manner similar to the manner as described in chapter 7 of said title "THE ART OF DIGITAL AUDIO". The sequence thus obtained of data bytes and added Q-redundancy bytes and added P-redundancy bytes is applied to a modulator circuit 35 of a customary type which converts the received sequence of bytes to a modulated signal adapted to the properties of the type of record carrier on which the data are to be recorded. In addition, the modulator adds the sync portions 2 and 3 to the modulated signal. The sync portions 2 and 3 can be supplied to the modulator 35 by a generator 37. The modulator 35 may be of a customary type such as is known, for example, by the name of EFM modulator. However, this modulator may also be of a different type as described in European Patent application No. 94200387.2 (14.746). The modulated signal produced by the modulator 35 is recorded in customary fashion on a record carrier 36, for example, a disc-like record carrier of an optically detectable type on which the modulated signal is represented by an optically detectable data pattern.

For the purpose of synchronization of the signal processing operations, which are performed by the various parts of the device shown in Fig. 3, the device comprises a clock signal generator 38 generating clock signals for the various parts.

Fig. 4 shows a device for reading the data recorded on the record carrier. This device comprises a read head (not shown) which scans the data pattern available on the record carrier and converts this pattern to a corresponding analog detection signal. The detection signal is applied to a so-termed slicer 40 which converts the analog detection signal to a corresponding binary read signal. The binary read signal is applied to a clock extraction circuit 41 for extracting a clock signal from the binary detection signal. The binary detection signal is further applied to a demodulation circuit 42 which reconverts the binary detection signal to a sequence of data bytes and P and Q-redundancy bytes. Besides, the demodulation circuit detects the sync portions 2 and 3. A signal denoting that a sync portion 2 or a sync portion 3 has been detected is fed to a signal line 44 by the demodulator 42. The data bytes and the added P and Q-redundancy bytes are applied to a circuit formed by a C1 decoder 45, an interleaver 46, a C2 decoder 47 and a deinterleaver 48, in this order. The interleaver 46 reorders the received bytes in a manner which is the reverse to the manner in which the bytes have been reordered by the deinterleaver 33. The deinterleaver 47 reorders the received bytes in a manner which is the reverse to the manner in which the bytes have been reordered by the interleaver 31. The C1 and C2 decoders detect and correct, in response to the P and Q-redundancy bytes, erroneously detected data bytes. The data bytes thus corrected are applied to a block deformatter 49 which separates the various types of data in the blocks and transfers these data to data processing arrangements (not shown). To simplify the establishment of the beginning of a block 1, the signal produced by the demodulator 42, which signal indicates that a sync portion 2 or 3 has been detected, is applied to the block deformatter *via* a time delay circuit 51 which delays the signal by a period of time corresponding to the delay of the circuit formed by the elements 45, 46, 47 and 48.

Furthermore, the device shown in Fig. 4 comprises a control circuit 52 which produces a plurality of clock signals which are in synchronism with the clock signal extracted by the clock extraction circuit, and which synchronous clock signals are applied to the various elements of the device to synchronize the operations performed by these elements.

Due to the use of the interleaver 46 and the deinterleaver 48 which reversely reorders the data bytes, the order in which the data bytes are produced by the demodulator 42 corresponds to the order in which the corrected data bytes are produced by the deinterleaver 48. This means that on the output of the demodulator 42 the data bytes are produced for complete blocks 1 at a time. This is advantageous in that the data bytes of the control portion of a block 1, be it in uncorrected form, become available on the output of the demodulator 42 substantially immediately after the bytes following a sync portion 2 or 3 have been read out. This control portion contains data used for searching for blocks recorded on the record carrier 1. Due to this rapid availability it is thus possible to have a rapid search of a desired block 1 on the record carrier in response to the data bytes available on the output of the demodulator 42.

The C1 decoder corrects single errors in response to the added P-redundancy bytes. Therefore, there should be a preference for using for the search control not the data bytes becoming available on the output of the demodulator 42, but the data bytes corrected for single errors, which bytes become available on an output of the C1 decoder. For the purpose of the separation of the control portion, which portion is necessary for search control, the device comprises a circuit 50 which is supplied with both the signal denoting that a sync portion 2 or 3 has been detected by the demodulator and with the data bytes processed by the C1 decoder. The data separated by circuit 50 are transported to an arrangement (not shown) for search control of blocks 1 on the record carrier 36. There should be preference for having the circuit 50 comprise an error detector which detects, in response to the CRC bytes in the control portions 20 of the blocks 1, whether the received bytes in the control portions contain errors. In this manner the probability of an erroneously received signal being used for searching for blocks 1 on the record carrier 36 is reduced.

## Claims

1. Record carrier on which is recorded a data signal representing data words, added first-type (Q) code words and added second-type (P) code words, the first-type code words having a predefined first relation to corresponding data words to form a first (C2) code, and the second-type code words having a predefined second relation to corresponding data words and first-type code words to form a second (C1) code, the predefined first and second relations enabling error correction in accordance with a predetermined algorithm, and the data signal being subdivided into addressable blocks (1) which comprise each a control portion (20) containing control data words and a data portion (21) containing user-supplied data words, characterized in that the first-type code words which are related to the data words of an associated block have been distributed over a first portion of the data signal corresponding to a plurality of recorded blocks, and the data words of said block and second-type code words related thereto have been distributed over a second portion of the data signal corresponding to a single recorded block.

2. Record carrier as claimed in Claim 1, characterized in that the control portion (21) contains added data words which have a predefined relation to data words in the control portion, whilst types of errors in the data words in the control portion can be detected in response to the data words and the added data words.

3. Record carrier as claimed in Claim 1 or 2, characterized in that the control portion comprises data words establishing a block address.

4. Device comprising reading means (40,41,42) for reading a data signal recorded on a record carrier as claimed in claim 1, which device comprises first (47) and second (45) error correcting means for correcting errors in the data words in response to the added first-type (Q) and second-type (P) code words, and means (46,48) coupled to said error correcting means for gathering the first-type code words from a first portion of the data signal corresponding to a plurality of recorded blocks and the data words of said block and second-type code words related thereto a said second portion of the data signal corresponding to a single recorded block.

5. Device as claimed in Claim 4, characterized in that the device comprises decoding means (50) for decoding the control portions of the blocks in response to data words which have at most been corrected in response to second-type code words.

6. Device as claimed in Claim 4 or 5, characterized in that the decoding means comprise error detection means for detecting errors in data in the control portion in response to added data words.

7. Device as claimed in Claim 4, 5 or 6, characterized in that the decoding means comprise means for deriving a block address from the control portion.

8. Device comprising writing means (35,37) for recording a data signal representing data words on a record carrier as claimed in claim 1, which device comprises first (32) and second (34) error encoding means for adding the first-type (Q) and second-type (P) code words, means (30) for subdividing the data signal into the addressable blocks, and interleaving means (31,33) coupled to said error correcting means for distributing the first-type code words (Q) over a first portion of the data signal corresponding to a plurality of recorded blocks and the data words of said block and second-type code words (P) related thereto over a second portion of the signal corresponding to a single recorded block.

9. Device as claimed in Claim 8, characterized in that the device comprises means (30) for including to the control portion added data words which have a predefined relation to data words in the control portion, whilst types of errors in the data words in the control portion can be detected in response to the data words and the added data words.

10. Device as claimed in Claim 8 or 9, characterized in that the device comprises means (30) for including in the control portion data words establishing a block address.

## Patentansprüche

1. Aufzeichnungsträger, auf dem ein Datensignal aufgezeichnet ist, das Datenwörter, zugefügte Codewörter eines ersten Typs (Q) und zugefügte Codewörter eines zweiten Typs (P) repräsentiert, wobei die Codewörter des ersten Typs eine zuvor definierte erste Beziehung zu entsprechenden Datenwörtern zum Bilden eines ersten (C2) Codes und die Codewörter des zweiten Typs eine zuvor definierte zweite Beziehung zu entsprechenden Datenwörtern und Codewörtern des ersten Typs zum Bilden eines zweiten (C1) Codes haben, wobei die zuvor definierten ersten und zweiten Beziehungen Fehlerkorrektur gemäß einem zuvor definierten Algorithmus ermöglichen, und wobei das Datensignal in adressierbare Blöcke (1) unterteilt ist, die jeweils einen Steuerabschnitt (20) umfassen, der Steuerdatenwörter enthält und einen Datenabschnitt (21), der vom Benutzer gelieferte Datenwörter enthält, dadurch gekennzeichnet, dass die Codewörter des ersten Typs, die mit den Datenwörtern eines zugehörigen Blockes zusammenhängen, über einen ersten Abschnitt des einer Vielzahl von aufgezeichneten Blöcken entsprechenden Datensignals verteilt sind und die Datenwörter des genannten Blockes und damit zusammenhängende Codewörter des zweiten Typs über einen zweiten Abschnitt des einem einzelnen aufgezeichneten Block entsprechenden Datensignals verteilt sind.

2. Aufzeichnungsträger nach Anspruch 1, dadurch gekennzeichnet, dass der Steuerabschnitt (21) zugefügte Datenwörter enthält, die eine zuvor definierte Beziehung zu Datenwörtern in dem Steuerabschnitt haben, wobei in Reaktion auf die Datenwörter und die zugefügten Datenwörter Arten von Fehlern in den Datenwörtern in dem Steuerabschnitt detektiert werden können.

3. Aufzeichnungsträger nach Anspruch 1 oder 2, dadurch gekennzeichnet, dass der Steuerabschnitt Datenwörter umfasst, die eine Blockadresse festlegen.

4. Einrichtung mit Auslesemitteln (40, 41, 42) zum Auslesen eines auf einem Aufzeichnungsträger nach Anspruch 1 aufgezeichneten Datensignals, welche Einrichtung erste (47) und zweite (45) Fehlerkorrekturmittel umfasst zum Korrigieren von Fehlern in den Datenwörtern in Reaktion auf die zugefügten Codewörter vom ersten Typ (Q) und zweiten Typ (P) und mit den genannten Fehlerkorrekturmitteln gekoppelte Mittel (46, 48) zum Sammeln der Codewörter vom ersten Typ aus einem ersten Abschnitt des einer Vielzahl von aufgezeichneten Blöcken entsprechenden Datensignals und der Datenwörter des genannten Blockes und dazu gehörender Codewörter vom zweiten Typ aus einem zweiten Abschnitt des einem einzelnen aufgezeichneten Block entsprechenden Datensignals.

5. Einrichtung nach Anspruch 4, dadurch gekennzeichnet, dass die Einrichtung Decodiermittel (50) umfasst zum Decodieren der Steuerabschnitte der Blöcke in Reaktion auf Datenwörter, die höchstens in Reaktion auf Codewörter vom zweiten Typ korrigiert worden sind.

6. Einrichtung nach Anspruch 4 oder 5, dadurch gekennzeichnet,dass die Decodiermittel Fehlerdetektionsmittel umfassen zum Detektieren von Fehlern in Daten in dem Steuerabschnitt in Reaktion auf zugefügte Datenwörter.

7. Einrichtung nach Anspruch 4, 5 oder 6, dadurch gekennzeichnet, dass die Decodiermittel Mittel zum Ableiten einer Blockadresse aus dem Steuerabschnitt umfassen.

8. Einrichtung mit Schreibmitteln (35, 37) zum Aufzeichnen eines Datenwörter repräsentierenden Datensignals auf einem Aufzeichnungsträger nach Anspruch 1, welche Einrichtung erste (32) und zweite (34) Fehlercodiermittel zum Hinzufügen der Codewörter vom ersten Typ (Q) und zweiten Typ (P) umfasst, Mittel (30) zum Unterteilen des Datensignals in die adressierbaren Blöcke und mit den genannten Fehlerkorrekturmitteln gekoppelte Verschachtelungsmittel (31, 33) zum Verteilen der Codewörter vom ersten Typ (Q) über einen ersten Abschnitt des einer Vielzahl von aufgezeichneten Blöcken entsprechenden Datensignals und der Datenwörter des genannten Blockes und dazu gehörender Codewörter vom zweiten Typ (P) über einen zweiten Abschnitt des einem einzelnen aufgezeichneten Block entsprechenden Datensignals.

9. Einrichtung nach Anspruch 8, dadurch gekennzeichnet, dass die Einrichtung Mittel (30) umfasst, um in den Steuerabschnitt zugefügte Datenwörter einzubringen, die eine zuvor definierte Beziehung zu Datenwörtern in dem Steuerabschnitt haben, während Arten von Fehlern in den Datenwörtern in dem Steuerabschnitt in Reaktion auf die Datenwörter und die zugefügten Datenwörter detektiert werden können.

10. Einrichtung nach Anspruch 8 oder 9, dadurch gekennzeichnet, dass die Einrichtung Mittel (30) umfasst, um in den Steuerabschnitt Datenwörter einzubringen, die eine Blockadresse festlegen.

## Revendications

1. Support d'enregistrement sur lequel est enregistré un signal de données représentant des mots de données, des mots de code ajoutés (Q) du premier type et des mots de code ajoutés (P) du deuxième type, les mots de code du premier type ayant une première relation prédéfinie avec des mots de données correspondants pour constituer un premier code (C2), et les mots de code du deuxième type ayant une deuxième relation prédéfinie avec des mots de code correspondants et avec des mots de code du premier type pour constituer un deuxième code (C1), les première et deuxième relations prédéfinies permettant une correction d'erreurs selon un algorithme prédéterminé, et le signal de données étant subdivisé en des blocs adressables (1) qui comportent chacun une partie de commande (20) contenant des mots de données de commande et une partie de données (21) contenant des mots de données d'usager, caractérisé en ce que les mots de code du premier type ayant rapport aux mots de données d'un bloc associé ont été distribués sur une première partie du signal de données correspondant à une pluralité de blocs enregistrés, et en ce que les mots de données dudit bloc et les mots de code du deuxième type y ayant rapport ont été distribués sur une deuxième partie du signal de données correspondant à un bloc enregistré unique.

2. Support d'enregistrement selon la revendication 1, caractérisé en ce que la partie de commande (21) contient des mots de données ajoutés qui présentent une relation prédéfinie avec des mots de données dans la partie de commande, alors que des types d'erreurs dans les mots de données présents dans la partie de commande peuvent être détectés en réaction aux mots de données et aux mots de données ajoutés.

3. Support d'enregistrement selon la revendication 1 ou 2, caractérisé en ce que la partie de commande comprend des mots de données fixant une adresse de bloc.

4. Dispositif comportant des moyens de lecture (40, 41, 42) pour lire un signal de données enregistré sur un support d'enregistrement selon la revendication 1, ledit dispositif comportant des premier (47) et deuxième (45) moyens de correction d'erreurs pour corriger des erreurs dans les mots de données en réaction aux mots de code ajoutés du premier type (Q) et du deuxième type (P), et des moyens (46, 48) couplés auxdits moyens de correction d'erreurs pour recueillir les mots de code du premier type à partir d'une première partie du signal de données correspondant à une pluralité de blocs enregistrés et aux mots de données dudit bloc, et des mots de code du deuxième type y ayant rapport à partir d'une deuxième partie du signal de données correspondant à un bloc enregistré unique.

5. Dispositif selon la revendication 4, caractérisé en ce que le dispositif comporte des moyens de décodage (50) pour décoder les parties de commande des blocs en réaction à des mots de données qui ont été corrigés en grande partie en réaction à des mots de code du deuxième type.

6. Dispositif selon la revendication 4 ou 5, caractérisé en ce que les moyens de décodage comportent des moyens de détection d'erreurs pour détecter en réaction à des mots de données ajoutés des erreurs dans des données présentes dans la partie de commande.

7. Dispositif selon la revendication 4, 5 ou 6, caractérisé en ce que les moyens de décodage comportent des moyens pour dériver une adresse de bloc de la partie de commande.

8. Dispositif comportant des moyens d'écriture (35, 37) pour enregistrer un signal de données représentant des mots de données sur un support d'enregistrement selon la revendication 1, ledit dispositif comportant des premier (32) et deuxième (34) moyens de codage d'erreurs pour ajouter les mots de code du premier type (Q) et du deuxième type (P), des moyens (30) pour subdiviser le signal de données en blocs adressables, et des moyens d'entrelacement (31, 33) couplés auxdits moyens de correction d'erreurs pour distribuer les mots de code du premier type (Q) sur une première partie du signal de données correspondant à une pluralité de blocs enregistrés et aux mots de données dudit bloc, et des mots de code du deuxième type (P) y ayant rapport sur une deuxième partie du signal de données correspondant à un bloc enregistré unique.

9. Dispositif selon la revendication 8, caractérisé en ce que le dispositif comporte des moyens (30) pour incorporer dans la partie de commande des mots de données ajoutés qui présentent une relation prédéfinie avec des mots de données présents dans la partie de commande, alors que des types d'erreurs dans les mots de données présents dans la partie de commande peuvent être détectés en réaction aux mots de données et aux mots de données ajoutés.

10. Dispositif selon la revendication 8 ou 9, caractérisé en ce que le dispositif comporte des moyens (30) pour incorporer dans la partie de commande des mots de données fixant une adresse de bloc.
